# FASCICULE DE BREVET EUROPEEN

(11) **EP 3 075 141 B1**
(45) Date de publication et mention de la délivrance du brevet: **02.09.2020**
(21) Numéro de dépôt: 14796184.1
(22) Date de dépôt: 24.09.2014
(51) Int. Cl.: H04N 5/232, H04Q 9/00, H05K 7/14, H04N 5/33

(54) **DISPOSITIF DE SURVEILLANCE PAR INFRAROUGE POUR ARMOIRE ELECTRIQUE**
VORRICHTUNG ZUR INFRAROTÜBERWACHUNG VON SCHALTSCHRÄNKEN
DEVICE FOR MONITORING BY INFRARED FOR ELECTRICAL CABINET

(30) Priorité: 28.11.2013 FR 1361745
(43) Date de publication de la demande: 05.10.2016
(73) Titulaire: Schneider Electric Industries SAS, 92500 Rueil-Malmaison (FR)
(72) Inventeur: COUTELOU, Olivier, 38050 Grenoble Cedex 09 (FR); GASSION, Romain, 38050 Grenoble Cedex 09 (FR)
(74) Mandataire: Tripodi, Paul
(86) Numéro de dépôt international: PCT/FR2014/052383
(87) Numéro de publication internationale: WO 2015/079128

(56) Documents cités:
- WO-A1-2012/044175
- WO-A2-2013/152122
- US-A1- 2010 231 407

## Description

### Domaine technique de l'invention

La présente invention se rapporte à un dispositif de surveillance pour armoire électrique. Ce dispositif de surveillance comporte notamment une unité de capture d'images photo et/ou vidéo pour surveiller l'installation électrique située à l'intérieur de l'armoire électrique.

### Etat de la technique

La surveillance des installations électriques situées dans les armoires électriques est devenue une priorité pour anticiper tout risque d'incendie. Pour cela, une inspection régulière de l'installation est nécessaire. Cette inspection est habituellement réalisée en ouvrant l'armoire électrique, ce qui nécessite un arrêt préalable de l'installation. Pour pallier cet inconvénient, de nouvelles solutions ont fait leur apparition. C'est le cas de celle décrite dans la demande de brevet WO2013/152122A2. Cette demande de brevet décrit une solution de surveillance par infrarouge de l'installation électrique située dans une armoire électrique. Cette solution comporte notamment une caméra thermique dirigée vers l'intérieur de l'armoire électrique et une unité de commande connectée à la caméra. La solution décrite dans ce document présente la particularité d'être sans-fil pour transmettre des images vers un système distant et autonome en énergie électrique, c'est-à-dire alimentée par induction grâce aux courants électriques circulant dans l'installation placée dans l'armoire électrique. La solution décrite dans ce document présente cependant le désavantage d'exposer une partie du dispositif aux agressions extérieures.

Le but de l'invention est de proposer un dispositif de surveillance destiné à se placer à l'intérieur d'un espace fermé, tel que par exemple une armoire électrique, ledit dispositif étant simple à installer et à utiliser et insensible aux agressions susceptibles de se produire à l'extérieur de l'armoire électrique.

### Exposé de l'invention

Ce but est atteint par un dispositif de surveillance destiné à être placé à l'intérieur d'un espace fermé, comprenant :
- Une unité de capture d'images photo et/ou vidéo pour capturer des images à l'intérieur de l'espace fermé,
- Une interface de communication pour communiquer, à travers une liaison de communication, avec un terminal mobile,
- Un microcontrôleur agencé pour commander l'unité de capture d'images photo et/ou vidéo,
- Une mémoire non volatile connectée au microcontrôleur et agencée pour stocker les images photo et/ou vidéo capturées par l'unité de capture d'images photo et/ou vidéo,
- Une interface d'alimentation en énergie électrique agencée pour récupérer une énergie électrique fournie par le terminal mobile,
- Des moyens de gestion de l'énergie électrique récupérée agencés pour alimenter l'unité de capture d'images photo et/ou vidéo, la mémoire non-volatile et le microcontrôleur.

Selon une particularité, l'interface d'alimentation comporte une architecture agencée pour récupérer l'énergie électrique par couplage magnétique avec le terminal mobile.

Selon une autre particularité, l'interface de communication comporte une antenne agencée pour communiquer à travers la liaison de communication avec le terminal mobile.

Selon une autre particularité, l'interface de communication et l'interface d'alimentation sont formées par un ou plusieurs composants électroniques agencés pour fonctionner selon une technologie de communication en champ proche ou de type RFID.

Selon une autre particularité, l'unité de capture d'images photo et/ou vidéo comporte une caméra thermique.

L'invention concerne également un système de surveillance incluant ledit dispositif décrit ci-dessus. Ce système de surveillance pour espace fermé comporte :
- Un dispositif de surveillance tel que défini ci-dessus, ledit dispositif étant destiné à être fixé sur une face interne d'une paroi de l'espace fermé,
- Un terminal mobile destiné à être placé de l'autre côté de ladite paroi, en vis-à-vis dudit dispositif de surveillance de manière à pouvoir communiquer avec ledit dispositif de dispositif à travers ladite liaison de communication et à alimenter ledit dispositif de surveillance.

Selon une particularité, le terminal mobile comporte un lecteur/encodeur fonctionnant en champ proche ou en RFID.

Selon une autre particularité, le terminal mobile comporte une mémoire pour stocker les images photos et/ou vidéos capturées par le dispositif de surveillance.

Selon une autre particularité, le terminal mobile comporte une application logicielle dédiée à la commande du dispositif de surveillance.

Selon une autre particularité, le terminal mobile comporte une interface homme-machine permettant ladite commande du dispositif de surveillance et la visualisation des images capturées par l'unité de capture d'images photo et/ou vidéo du dispositif.

Selon une autre particularité, le système comporte un support destiné à être fixé sur la face externe de ladite paroi de l'espace fermé et agencé pour accueillir le terminal mobile.

### Brève description des figures

D'autres caractéristiques et avantages vont apparaître dans la description détaillée qui suit faite en regard des dessins annexés dans lesquels :
- la figure 1 représente, de manière schématique et en vue de côté, le système de l'invention positionné sur une armoire électrique,
- la figure 2 représente de manière schématique l'architecture du système de surveillance de l'invention.

### Description détaillée d'au moins un mode de réalisation

L'invention concerne un dispositif de surveillance 1 destiné à être placé à l'intérieur d'un espace fermé et un système de surveillance incluant ledit dispositif 1.

Par espace fermé, on entend un espace dans lequel on souhaite visualiser l'état d'une installation sans avoir à accéder à cet espace. Il s'agira par exemple d'une armoire électrique 3 logeant une installation électrique 4 à inspecter régulièrement, ladite installation 4 comportant une pluralité d'appareillages 40 électriques. Dans la suite de la description, on prendra une armoire électrique 3 comme exemple d'application du système de l'invention.

Le principe de l'invention consiste à utiliser un terminal mobile 2 pour alimenter le dispositif de surveillance 1 situé dans l'armoire électrique 3 et pour visualiser l'état de l'installation électrique 4 sur l'écran 20 du terminal mobile.

Le système de surveillance de l'invention comporte ainsi un dispositif de surveillance 1 destiné à être placé à l'intérieur de l'armoire électrique 3, en étant par exemple fixé sur la face interne f1 de la porte de l'armoire électrique 3 et un terminal mobile 2 destiné à être positionné à l'extérieur de l'armoire électrique 3, en vis-à-vis du dispositif de surveillance 1. Un support spécifique 30 pourra par exemple être réalisé sur la face externe f2 de la porte de l'armoire 3 pour accueillir le terminal mobile 2.

Le terminal mobile 2 est par exemple un téléphone mobile de type téléphone intelligent ou tablette comprenant une unité de traitement et une mémoire. Il comporte une interface homme-machine telle que par exemple un écran 20 tactile. Il comporte également un module de communication lui permettant d'échanger des données sur une liaison de communication L. En plus de son module de communication, le terminal mobile 2 est équipé d'un module d'alimentation électrique permettant d'alimenter un dispositif présent à sa portée. Le module de communication et le module d'alimentation sont par exemple regroupés dans un lecteur/encodeur fonctionnant en champ proche ("NFC" pour "Near Field Communication") ou en RFID ("Radio Frequency Identification"). De manière connue, ce lecteur/encodeur 21 comporte une antenne 22 par laquelle il génère un champ magnétique permettant d'alimenter, par couplage magnétique, un dispositif externe positionné à sa portée et de communiquer avec ce dispositif. Le terminal mobile 2 comporte bien entendu une source d'alimentation telle que par exemple une batterie, de laquelle est prélevée l'énergie électrique transférée vers l'extérieur grâce à son module d'alimentation.

Le terminal mobile 2 comporte préférentiellement une application logicielle dédiée permettant de commander le dispositif de surveillance 1. Cette application logicielle est alors configurée pour interagir avec le dispositif de surveillance 1. Elle est par exemple exécutée dès lors que le terminal mobile 2 a détecté la présence du dispositif de surveillance 1 situé à sa portée.

La détermination de l'application logicielle à exécuter est par exemple réalisée sur la base d'un identifiant unique du dispositif de surveillance 1. Dans le terminal mobile 2, l'association entre l'identifiant unique du dispositif de surveillance 1 et l'application logicielle à exécuter peut être réalisée de différentes manières. Il peut s'agir par exemple d'un paramétrage réalisé par l'utilisateur lors de la première détection.

Pour commander, lire et/ou configurer le dispositif de surveillance 1, l'application logicielle s'appuie notamment sur l'interface homme-machine du terminal mobile 2.

Le terminal mobile 2 comporte par ailleurs une interface de communication lui permettant de communiquer sur un réseau de communication R afin, par exemple, de transférer les données du dispositif de surveillance 1 ou de récupérer des données en provenance d'un serveur 5 distant. Ce réseau de communication R est préférentiellement un réseau sans-fil fonctionnant par exemple selon un protocole de communication de type WIFI, 3G, 4G ou autre solution similaire.

Le dispositif de surveillance 1 est destiné à la surveillance de l'installation électrique 4 située à l'intérieur de l'armoire électrique 3.

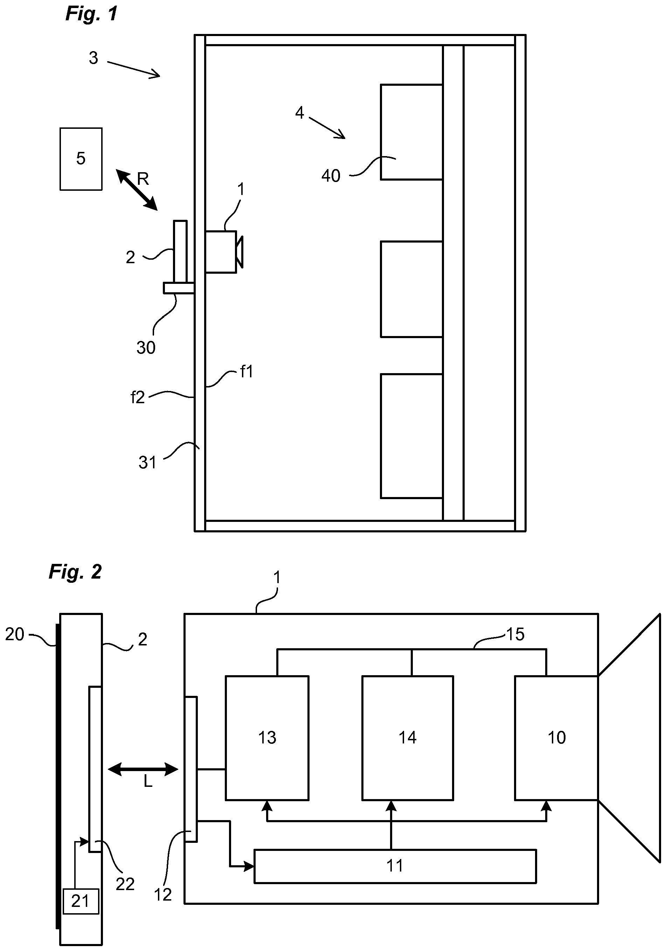

En référence à la figure 2, le dispositif de surveillance 1 comporte une unité 10 de capture d'images photo et/ou vidéo pour capturer des images de l'installation électrique 4 située à l'intérieur de l'armoire électrique 3. Cette unité de capture 10 consiste par exemple en une caméra thermique basse résolution (8*16 pixels par exemple) qui délivre une température moyenne par pixel correspondant à la zone couverte par ce pixel. Une telle caméra permet de déterminer un tableau de températures dans lequel chaque case correspond à une zone précise du champ de la caméra thermique. Dans une application de type armoire électrique, la caméra thermique est préférentiellement choisie avec un optique grand angle afin de pouvoir couvrir l'ensemble de l'installation 4 située dans l'armoire 3.

Le dispositif de surveillance comporte une interface de communication afin de pouvoir communiquer avec le terminal mobile. Ladite interface de communication comporte au moins une antenne 12 agencée pour permettre au dispositif de surveillance de communiquer sur la liaison de communication L avec le lecteur/encodeur 21 du terminal mobile, grâce à la technologie en champ proche de type NFC ou RFID. Les données représentatives des photos et/ou vidéos capturées par l'unité 10 de capture d'images sont ainsi transférées à travers la porte 31 de l'armoire électrique 3, via l'interface de communication, vers le terminal mobile 2. L'application logicielle du terminal mobile 2 est ensuite agencée pour mémoriser lesdites images photos et/ou vidéos capturées et/ou afficher lesdites images photos et/ou vidéos capturées sur son écran 20 et/ou transmettre lesdites images photos et/ou vidéo sur le réseau de communication R.

Le dispositif de surveillance 1 comporte une mémoire 13 non volatile, par exemple de type EEPROM.

Le dispositif de surveillance 1 comporte des moyens de traitement tels que par exemple un microcontrôleur 14. Le microcontrôleur 14 est agencé pour commander l'écriture et la lecture de données dans la mémoire 13 non volatile et pour commander l'unité 10 de capture d'images photo et/ou vidéo. Le microcontrôleur 14, l'unité 10 de capture d'images photo et/ou vidéo et la mémoire 13 non volatile sont connectés entre eux, par une liaison multipoints de type bus interne 15, tel que par exemple un bus I2C (pour "Inter integrated Circuit").

Selon l'invention, le dispositif de surveillance 1 ne comporte aucune source d'alimentation électrique interne, c'est-à-dire aucune pile ou batterie non-rechargeable. Le dispositif de surveillance 1 comporte une interface d'alimentation en énergie électrique. Préférentiellement, cette interface d'alimentation en énergie électrique est sans fil et est agencé pour générer une énergie électrique nécessaire à l'alimentation des circuits internes du dispositif, c'est-à-dire au moins le microcontrôleur 14, l'unité 10 de capture d'images photo et/ou vidéo et la mémoire 13 non volatile.

Préférentiellement, l'interface d'alimentation en énergie électrique comporte une antenne agencée pour générer une énergie électrique par couplage magnétique avec le lecteur/encodeur 21 NFC ou RFID du terminal mobile 2.

Préférentiellement, pour communiquer avec le terminal mobile et pour récupérer l'énergie électrique par couplage magnétique avec le lecteur/encodeur 21 NFC ou RFID du terminal mobile 2, l'interface de communication et l'interface d'alimentation sont formées par un ou plusieurs composants électroniques adaptés pour fonctionner selon la technologie NFC ou RFID. Lesdits composants comprennent par exemple ladite mémoire 13 non-volatile, le microcontrôleur 14 et l'antenne 12 destinée à rentrer en couplage magnétique avec l'antenne 22 du lecteur/encodeur 21 inclus dans le terminal mobile 2. Le dispositif de surveillance 1 peut ainsi être alimentée par la "porteuse" émise à partir de l'antenne 22 du lecteur/encodeur 21 du terminal mobile 2 et communiquer sur la liaison de communication L avec le terminal mobile 2 par modulation de fréquence et/ou d'amplitude. L'énergie captée par l'antenne 12 du dispositif est transformée en énergie électrique.

Le dispositif de surveillance 1 comporte également des moyens 11 de gestion de l'énergie électrique récupérée via l'interface d'alimentation. Les moyens 11 de gestion de l'énergie électrique sont agencés 1 pour distribuer l'énergie électrique aux composants du dispositif, c'est-à-dire principalement le microcontrôleur 14, la mémoire 13 non volatile et l'unité 10 de capture d'images photo et/ou vidéo.

La technologie NFC ou RFID implique le stockage d'un identifiant unique dans la mémoire 13 non volatile du dispositif. Comme décrit ci-dessus, cet identifiant unique est associé dans le terminal mobile 2 à une application logicielle à exécuter sur le terminal mobile 2. Lorsque le terminal mobile 2 est à portée du dispositif de surveillance 1, le terminal mobile 2 envoie une requête initiale au dispositif afin de récupérer son identifiant unique. En réponse, le dispositif de surveillance 1 lui envoie son identifiant unique stocké dans sa mémoire 13 non volatile. Le terminal mobile 2 exécute alors l'application logicielle associée à cet identifiant unique et peut par exemple proposer à l'opérateur d'ouvrir l'historique des images photos et/ou vidéo prises antérieurement par ce dispositif.

Selon l'invention, le système de surveillance de l'invention fonctionnera par exemple de la manière suivante :
- un opérateur, désireux d'inspecter l'installation électrique 4 située dans une armoire électrique 4, positionne son terminal mobile 2 dans le support 30 fixé sur la face externe f2 de la porte 31 de l'armoire électrique 3.
- Le dispositif de surveillance 1 positionné sur la face interne f1 de la porte 31 de l'armoire électrique 3, en vis-à-vis du terminal mobile 2, est alors énergisé par le terminal mobile, 2 via la technologie en champ proche.
- Le terminal mobile 2 charge le dispositif de surveillance 1 en énergie électrique. L'énergie électrique est amenée vers les moyens 14 de gestion de l'énergie électrique récupérée.
- Les moyens 11 de gestion de l'énergie électrique alimentent alors le microcontrôleur.
- Par la technologie en champ proche, le terminal mobile 2 envoie une requête au dispositif de surveillance 1 afin de récupérer son identifiant unique. En réponse à la requête, le microcontrôleur 14 envoie l'identifiant unique du dispositif de surveillance.
- Le terminal mobile 2 exécute l'application logicielle associée à l'identifiant unique du dispositif de surveillance 1.
- Le dispositif de surveillance 1 peut éventuellement gérer des droits d'accès, tenant compte de l'identifiant du terminal mobile 2 approché.
- A partir de l'application logicielle exécutée sur le terminal mobile 2 et via la liaison de communication L, le terminal mobile 2 écrit dans la mémoire 13 non volatile du dispositif de surveillance 1 une requête de capture d'une image photo et/ou vidéo de l'installation électrique 4.
- Via le bus interne 15, le microcontrôleur 14 du dispositif de surveillance 1 lit la requête écrite dans la mémoire 13 non volatile et envoie une commande à l'unité 10 de capture d'images photo et/ou vidéo pour la prise d'une image photo et/ou vidéo de l'installation 4.
- Les données représentatives de l'image photo et/ou vidéo capturée par l'unité 10 de capture sont transmises via le bus interne 15 et écrites dans la mémoire 13 non volatile. En réponse à la requête, le microcontrôleur 14 commande l'envoi desdites données par la technologie en champ proche vers le terminal mobile 2.
- Le terminal mobile 2 lit les données reçues et affiche sur son écran 20, par l'intermédiaire de son application logicielle, l'image photo et/ou vidéo capturée par le dispositif de surveillance 1. Par ailleurs, il peut également mémoriser ladite image et/ou la transmettre à un serveur 5 distant via le réseau de communication R.
- Le retrait du terminal mobile 2 du support 30 stoppe l'alimentation en énergie électrique du dispositif de surveillance 1. L'opérateur peut ensuite traiter et analyser l'image reçue, la stocker en local et/ou la transférer vers un serveur 5 distant via le réseau de communication R.

La solution de l'invention présente ainsi de nombreux avantages, parmi lesquels
- Facilité d'inspection d'une alimentation électrique 4, par exemple située dans une armoire électrique 3, en employant un simple terminal mobile 2, sans ouvrir la porte 31 de l'armoire électrique 3,
- Facilité d'analyse de l'image photo et/ou vidéo capturée, celle-ci étant toujours prise dans la même position et dans la même configuration, permettant des comparaisons et un suivi dans le temps de la situation thermique de l'installation 4,
- Facilité de maintenance du dispositif de surveillance 1 car celui-ci ne possède ni source d'énergie interne à remplacer, ni connectique,
- Possibilité d'équiper le dispositif de surveillance 1 d'une unité de capture à faible coût, l'écran de visualisation de l'image photo et/ou vidéo étant celui du terminal mobile 2.
- Utilisation d'une technologie en champ proche de plus en plus répandu dans les terminaux mobiles,
- Possibilité d'intégrer le dispositif de surveillance 1 à la porte 31 de l'armoire électrique et de proposer à la vente une armoire 3 intégrant ledit dispositif 1.

## Revendications

1. Dispositif de surveillance (1) destiné à être placé à l'intérieur d'un espace fermé, ledit dispositif comprenant :
- Une unité (10) de capture d'images photo et/ou vidéo pour capturer des images à l'intérieur de l'espace fermé,
- Une interface de communication pour communiquer, à travers une liaison de communication (L), avec un terminal mobile (2),
- Un microcontrôleur (14) agencé pour commander l'unité (10) de capture d'images photo et/ou vidéo,
- Une mémoire (13) non volatile connectée au microcontrôleur (14) et agencée pour stocker les images photo et/ou vidéo capturées par l'unité (10) de capture d'images photo et/ou vidéo,
le dispositif étant **caractérisé en ce qu'**il comporte :
- Une interface d'alimentation en énergie électrique agencée pour récupérer une énergie électrique fournie par le terminal mobile (2),
- Des moyens (11) de gestion de l'énergie électrique récupérée agencés pour alimenter l'unité de capture d'images photo et/ou vidéo, la mémoire non-volatile et le microcontrôleur.

2. Dispositif selon la revendication 1, **caractérisé en ce que** l'interface d'alimentation comporte une architecture agencée pour récupérer l'énergie électrique par couplage magnétique avec le terminal mobile (2).

3. Dispositif selon la revendication 2, **caractérisé en ce que** l'interface de communication comporte une antenne (12) agencée pour communiquer à travers la liaison de communication (L) avec le terminal mobile (2).

4. Dispositif selon la revendication 3, **caractérisé en ce que** l'interface de communication et l'interface d'alimentation sont formées par un ou plusieurs composants électroniques agencés pour fonctionner selon une technologie de communication en champ proche ou de type RFID.

5. Dispositif selon l'une des revendications 1 à 4, **caractérisé en ce que** l'unité (10) de capture d'images photo et/ou vidéo comporte une caméra thermique.

6. Système de surveillance pour espace fermé, **caractérisé en ce qu'**il comporte :
- Un dispositif de surveillance (1) tel que défini dans l'une des revendications 1 à 6, ledit dispositif étant destiné à être fixé sur une face interne (f1) d'une paroi de l'espace fermé,
- Un terminal mobile (2) destiné à être placé de l'autre côté de ladite paroi, en vis-à-vis dudit dispositif de surveillance (1) de manière à pouvoir communiquer avec ledit dispositif de dispositif (1) à travers ladite liaison de communication (L) et à alimenter ledit dispositif de surveillance (1).

7. Système de surveillance selon la revendication 6, **caractérisé en ce que** le terminal mobile (2) comporte un lecteur/encodeur (21) fonctionnant en champ proche ou en RFID.

8. Système de surveillance selon la revendication 6 ou 7, **caractérisé en ce que** le terminal mobile (2) comporte une mémoire pour stocker les images photos et/ou vidéos capturées par le dispositif de surveillance (1).

9. Système de surveillance selon l'une des revendications 6 à 8, **caractérisé en ce que** le terminal mobile (2) comporte une application logicielle dédiée à la commande du dispositif de surveillance (1).

10. Système de surveillance selon l'une des revendications 6 à 9, **caractérisé en ce que** le terminal mobile (2) comporte une interface homme-machine permettant ladite commande du dispositif de surveillance (1) et la visualisation des images capturées par l'unité de capture d'images photo et/ou vidéo du dispositif.

11. Système de surveillance selon l'une des revendications 6 à 10, **caractérisé en ce qu'**il comporte un support (30) destiné à être fixé sur une face externe de (f2) de ladite paroi de l'espace fermé et agencé pour accueillir le terminal mobile (2).

## Patentansprüche

1. Überwachungsvorrichtung (1), welche dazu bestimmt ist, im Inneren eines geschlossenen Raumes angeordnet zu werden, wobei die Vorrichtung umfasst:
- eine Einheit (10) zur Erfassung von fotografischen Bildern und/oder Videobildern zum Erfassen von Bildern im Inneren des geschlossenen Raumes,
- eine Kommunikationsschnittstelle zum Kommunizieren, über eine Kommunikationsverbindung (L), mit einem mobilen Endgerät (2),
- einen Mikrocontroller (14), der dafür ausgelegt ist, die Einheit (10) zur Erfassung von fotografischen Bildern und/oder Videobildern zu steuern,
- einen nichtflüchtigen Speicher (13), der mit dem Mikrocontroller (14) verbunden ist und dafür ausgelegt ist, die fotografischen Bilder und/oder Videobilder zu speichern, die von der Einheit (10) zur Erfassung von fotografischen Bildern und/oder Videobildern erfasst wurden,
wobei die Vorrichtung **dadurch gekennzeichnet ist, dass** sie aufweist:
- eine Schnittstelle zur Versorgung mit elektrischer Energie, die dafür ausgelegt ist, elektrische Energie zurückzugewinnen, die von dem mobilen Endgerät (2) geliefert wird,
- Mittel (11) zum Management der zurückgewonnenen elektrischen Energie, die dafür ausgelegt sind, die Einheit zur Erfassung von fotografischen Bildern und/oder Videobildern, den nichtflüchtigen Speicher und den Mikrocontroller zu versorgen.

2. Vorrichtung nach Anspruch 1, **dadurch gekennzeichnet, dass** die Versorgungsschnittstelle eine Architektur aufweist, die dafür ausgelegt ist, die elektrische Energie durch magnetische Kopplung mit dem mobilen Endgerät (2) zurückzugewinnen.

3. Vorrichtung nach Anspruch 2, **dadurch gekennzeichnet, dass** die Kommunikationsschnittstelle eine Antenne (12) aufweist, die dafür ausgelegt ist, über die Kommunikationsverbindung (L) mit dem mobilen Endgerät (2) zu kommunizieren.

4. Vorrichtung nach Anspruch 3, **dadurch gekennzeichnet, dass** die Kommunikationsschnittstelle und die Versorgungsschnittstelle von einer oder mehreren elektronischen Komponenten gebildet werden, die dafür ausgelegt sind, gemäß einer Nahfeld- oder RFID-Kommunikationstechnologie zu funktionieren.

5. Vorrichtung nach einem der Ansprüche 1 bis 4, **dadurch gekennzeichnet, dass** die Einheit (10) zur Erfassung von fotografischen Bildern und/oder Videobildern eine Wärmebildkamera aufweist.

6. Überwachungssystem für einen geschlossenen Raum, **dadurch gekennzeichnet, dass** es umfasst:
- eine Überwachungsvorrichtung (1), wie in einem der Ansprüche 1 bis 6 definiert, wobei die Vorrichtung dazu bestimmt ist, an einer Innenseite (f1) einer Wand des geschlossenen Raumes befestigt zu werden,
- ein mobiles Endgerät (2), das dazu bestimmt ist, auf der anderen Seite dieser Wand gegenüber der Überwachungsvorrichtung (1) angeordnet zu werden, derart, dass es mit der Vorrichtungsvorrichtung (1) über die Kommunikationsverbindung (L) kommunizieren kann und die Überwachungsvorrichtung (1) mit Strom versorgt.

7. Überwachungssystem nach Anspruch 6, **dadurch gekennzeichnet, dass** das mobile Endgerät (2) ein Lesegerät/einen Codierer (21) aufweist, das/der im Nahfeld oder mit RFID funktioniert.

8. Überwachungssystem nach Anspruch 6 oder 7, **dadurch gekennzeichnet, dass** das mobile Endgerät (2) einen Speicher zum Speichern der fotografischen Bilder und/oder Videobilder aufweist, die von der Überwachungsvorrichtung (1) erfasst wurden.

9. Überwachungssystem nach einem der Ansprüche 6 bis 8, **dadurch gekennzeichnet, dass** das mobile Endgerät (2) eine Softwareanwendung für die Steuerung der Überwachungsvorrichtung (1) aufweist.

10. Überwachungssystem nach einem der Ansprüche 6 bis 9, **dadurch gekennzeichnet, dass** das mobile Endgerät (2) eine Mensch-Maschine-Schnittstelle aufweist, welche die Steuerung der Überwachungsvorrichtung (1) und die Visualisierung der Bilder, die von der Einheit zur Erfassung von fotografischen Bildern und/oder Videobildern der Vorrichtung erfasst wurden, ermöglicht.

11. Überwachungssystem nach einem der Ansprüche 6 bis 10, **dadurch gekennzeichnet, dass** es eine Halterung (30) aufweist, die dazu bestimmt ist, an einer Außenseite (f2) der Wand des geschlossenen Raumes befestigt zu werden, und dafür ausgelegt ist, das mobile Endgerät (2) aufzunehmen.

## Claims

1. Monitoring device (1) intended to be placed inside a closed space, said device comprising:
- a photo and/or video image capture unit (10) for capturing images inside the closed space;
- a communication interface for communicating, through a communication link (L), with a mobile terminal (2);
- a microcontroller (14) arranged to control the photo and/or video image capture unit (10);
- a non-volatile memory (13) connected to the microcontroller (14) and arranged to store the photo and/or video images captured by the photo and/or video image capture unit (10),
the device being **characterized in that** it includes:
- an electrical power supply interface arranged to collect electrical power supplied by the mobile terminal (2);
- collected electrical power management means (11) arranged to supply the photo and/or video image capture unit, the non-volatile memory and the microcontroller with power.

2. Device according to Claim 1, **characterized in that** the power supply interface includes an architecture that is arranged to collect the electrical power by means of magnetic coupling with the mobile terminal (2).

3. Device according to Claim 2, **characterized in that** the communication interface includes an antenna (12) that is arranged to communicate with the mobile terminal (2) through the communication link (L).

4. Device according to Claim 3, **characterized in that** the communication interface and the power supply interface are formed by one or more electronic components that are arranged to operate using near-field-communication or RFID technology.

5. Device according to one of Claims 1 to 4, **characterized in that** the photo and/or video image capture unit (10) includes a thermal camera.

6. Monitoring system for a closed space, **characterized in that** it includes:
- a monitoring device (1) such as defined in one of Claims 1 to 6, said device being intended to be fixed to an inner face (f1) of a wall of the closed space;
- a mobile terminal (2) that is intended to be placed on the other side of said wall, opposite said monitoring device (1) so as to be able to communicate with said device device (1) through said communication link (L) and to supply said monitoring device (1) with power.

7. Monitoring system according to Claim 6, **characterized in that** the mobile terminal (2) includes a reader/encoder (21) that operates by near-field or by RFID.

8. Monitoring system according to Claim 6 or 7, **characterized in that** the mobile terminal (2) includes a memory for storing the photo and/or video images captured by the monitoring device (1).

9. Monitoring system according to one of Claims 6 to 8, **characterized in that** the mobile terminal (2) includes a dedicated software application for controlling the monitoring device (1).

10. Monitoring system according to one of Claims 6 to 9, **characterized in that** the mobile terminal (2) includes a human-machine interface allowing said control of the monitoring device (1) and the viewing of the images captured by the photo and/or video image capture unit of the device.

11. Monitoring system according to one of Claims 6 to 10, **characterized in that** it includes a support (30) that is intended to be fixed to an outer face (f2) of said wall of the closed space and arranged to accommodate the mobile terminal (2).
